# EUROPEAN PATENT APPLICATION

(11) **EP 4 822 885 A1**
(43) Date of publication of application: **14.10.2026**
(21) Application number: 25194850.1
(22) Date of filing: 08.08.2025
(51) Int. Cl.: H01M 50/569, H01M 10/42, G01R 31/364, H01M 50/15, H01M 10/48

(54) **BATTERY CELL MONITORING MODULE**

(30) Priority: 09.04.2025 TW 114113304
(71) Applicant: DELTA ELECTRONICS, INC., Taoyuan City 320023 (TW)
(72) Inventor: WU, Chih-Yu, 320023 Taoyuan City (TW); PENG, Yen-Kai, 320023 Taoyuan City (TW); LEE, Jen-Feng, 320023 Taoyuan City (TW)
(74) Representative: 2K Patent Partnerschaft mbB

(57) **Abstract**

A battery cell monitoring module having a battery cell (10), a circuit board (20), a positive conductor (30), and a negative conductor (40) is provided. The battery cell (10) has a positive electrode head (11) and a negative electrode head (12). The circuit board (20) has a positive power pad (21), a positive voltage pad (22), a negative power pad (23), and a negative voltage pad (24). The positive conductor (30) is arranged on the battery cell (10) and includes a positive power pin (32) electrically connected to the positive electrode head (11) and the positive power pad (21) and a positive voltage pin (33) electrically connected to the positive electrode head (11) and the positive voltage pad (22). The negative conductor (40) is arranged on the battery cell (10) and includes a negative power pin (42) electrically connected to the negative electrode head (12) and the negative power pad (23) and a negative voltage pin (43) electrically connected to the negative electrode head (12) and the negative voltage pad (24).

## Description

### BACKGROUND

### Technical Field

The present disclosure relates to a battery module, particularly to a battery cell monitoring module capable of directly measuring a voltage of the battery cell therein.

### Description Of Related Art

Battery cells are widely used because of their light weight, large capacity and safety, and they are usually equipped with a voltage sensor or a voltage detection circuit to measure their voltage during use, such that users may monitor a battery status inside the battery cell at any time. However, the voltage sensor or voltage detection circuit used in existing battery cells connects a positive electrode and a negative electrode of the battery cell respectively by two conductive wires. Therefore, the voltage measurement would be affected by the large current to influence its stability and accuracy, and it is also not easy to perform electrochemical impedance spectroscopy (EIS) measurement on the battery cell.

In addition, most existing battery cells are welded to busbars after installation to conduct and distribute current. Therefore, when the existing battery cells monitor the temperature, they usually use sensors to measure a temperature of the busbars directly instead of themselves, such that a measured temperature has a discrepancy with an actual temperature of the battery cells. On the other hand, users may not know the temperature and the condition of the battery cells before they are welded to the busbars.

In view of the above, the inventor seeks to overcome the aforementioned drawbacks associated with the current technology and aims to provide an effective solution through extensive researches along with utilization of academic principles and knowledge.

### SUMMARY

The primary objective of the present disclosure is to reduce interference or influence from other circuits such as power when the circuit board measures the temperature of the voltage of the battery cell, so as to improve the stability and accuracy of voltage measurement.

To accomplish the aforementioned objective, the present disclosure provides a battery cell monitoring module having a battery cell, a circuit board, a positive conductor, and a negative conductor. The battery cell has a positive electrode head, a negative electrode head, and an insulating cover. The positive electrode head and the negative electrode head are arranged on the insulating cover. The circuit board is arranged on the insulating cover and comprising a positive power pad, a positive voltage pad, a negative power pad, and a negative voltage pad. The positive conductor is arranged on the battery cell and includes a positive connecting portion, a positive power pin, and a positive voltage pin. The positive connecting portion is electrically connected to the positive electrode head. The positive power pin is electrically connected to the positive connecting portion and the positive power pad. The positive voltage pin is electrically connected to the positive connecting portion and the positive voltage pad. The negative conductor is arranged on the battery cell and has a negative connecting portion, a negative power pin, and a negative voltage pin. The negative connecting portion is electrically connected to the negative electrode head. The negative power pin is electrically connected to the negative connecting portion and the negative power pad. The negative voltage pin is electrically connected to the negative connecting portion and the negative voltage pad.

Another aspect of the present disclosure provides that the positive conductor has a positive buffer portion, the positive buffer portion is arranged on at least one of the positive power pin and the positive voltage pin.

Another aspect of the present disclosure provides that the positive buffer portion is arc-shaped, V-shaped, or U-shaped.

Another aspect of the present disclosure provides that the negative conductor has a negative buffer portion, the negative buffer portion is arranged on at least one of the negative power pin and the negative voltage pin.

Another aspect of the present disclosure provides that the negative buffer portion is arc-shaped, V-shaped, or U-shaped.

Another aspect of the present disclosure provides that the positive connecting portion and the negative connecting portion are both strip-shaped, rectangle, arc, semicircle, or ring-shaped.

Another aspect of the present disclosure provides that the positive power pin, the positive voltage pin, the negative power pin, and the negative voltage pin are all strip-shaped, plate-shaped, or line-shaped.

Another aspect of the present disclosure provides that further includes an outer cover, the outer cover is arranged on the insulating cover and covers at least part of the circuit board, at least part of the positive conductor, and at least part of the negative conductor.

Another aspect of the present disclosure provides that the battery cell has an exhaust valve, the circuit board has a through slot, a position of the through slot is corresponding to a position of the exhaust valve.

Another aspect of the present disclosure provides that the battery cell has an exhaust valve, the exhaust valve is arranged between the circuit board and the positive conductor or between the circuit board and the negative conductor.

In the battery cell monitoring module of the present disclosure, the positive conductor has the positive power pin and the positive voltage pin that are respectively electrically connected to the positive power pad and the positive voltage pad of the circuit board, and the negative conductor has the negative power pin and the negative voltage pin that are respectively electrically connected to the negative power pad and the negative voltage pad of the circuit board. Therefore, the battery cell may form an independent circuit with the circuit board through the positive power pin and the negative power pin to supply power, and the circuit board may measure the voltage of the battery cell through the positive voltage pin and the negative voltage pin to reduce interference or influence from other circuits such as power, so as to improve the stability and accuracy of voltage measurement.

### BRIEF DESCRIPTION OF THE DRAWINGS

FIG. 1 is a perspective appearance view of the first embodiment of the present disclosure;
FIG. 2 is a circuit diagram of the battery cell, the positive conductor, the negative conductor, and the circuit board of the present disclosure;
FIG. 3 is a perspective appearance view of rear side of the circuit board of the present disclosure;
FIG. 4 is a partial perspective appearance view of the second embodiment of the present disclosure;
FIG. 5 is a partial perspective appearance view of the third embodiment of the present disclosure;
FIG. 6 is a partial perspective appearance view of the fourth embodiment of the present disclosure;
FIG. 7 is a partial perspective appearance view of the fifth embodiment of the present disclosure;
FIG. 8 is a partial exploded view of the sixth embodiment of the present disclosure; and

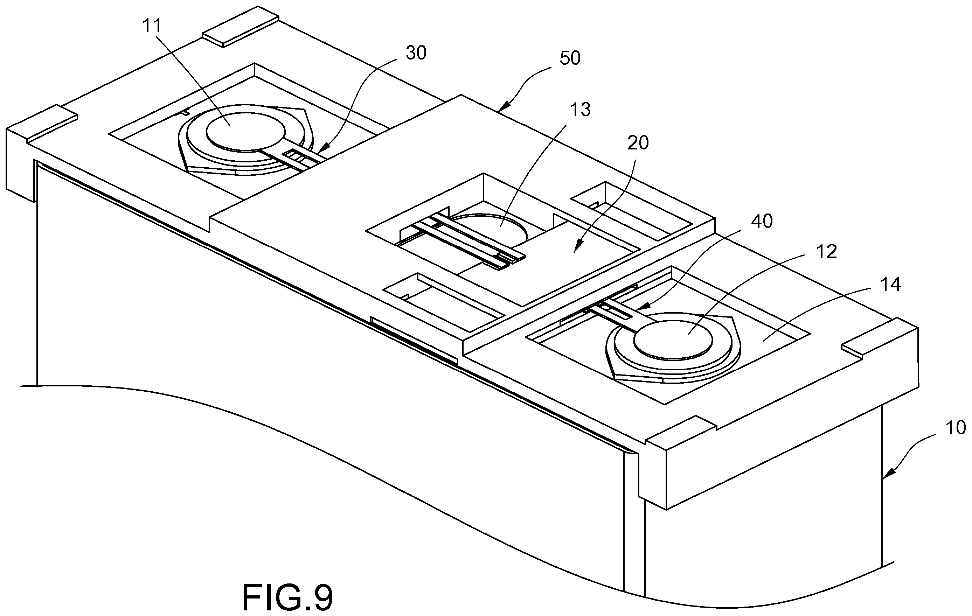

FIG. 9 is a partial perspective appearance view of the sixth embodiment of the present disclosure.

### DETAILED DESCRIPTION

It is to be understood that the terms for indicating positions and the location relation, for example "front", "rear", "left", "right", "front end", "rear end", "distal end", "longitudinal direction", "lateral direction", "vertical direction", "top" and "bottom", are based on the positions and the location relation disclosed in the drawings, and only used for disclosing the present disclosure and not used for indicating or implying the specified location of the device or the components or the specified structure and operation in certain location, thus the present disclosure is not intended to be limiting.

For example, the terms of "first", "second", "third", "forth" and "fifth" are used for illustrating each unit, component, area, layer and/or part. The component, the unit, the area, the layer and/or the part are not limited by the terms. These terms are only used for separating the element, the assembly, the area, the layer, or the part. Unless being clearly indicated according to the whole specification, the terms for example "the first", "the second", "the third", "the fourth" and "the fifth" are not used for implying the order or sequence.

As used herein and not otherwise defined, the terms "substantially" and "approximately" are used to describe and describe small changes. When used in connection with an event or situation, the terms may include the precise moment at which the event or situation occurs, as well as the event or situation occurring to a close approximation. For example, when combined with a numerical value, the terms may include a range of variation equal to or less than ±5% of the numerical value, such as equal to or less than ±4%, equal to or less than ±3%, equal to or less than ±2%, equal to or less than ±1%, equal to or less than ±0.5%, equal to or less than ±0.1%, or equal to or less than ±0.05%.

The technical contents of the present disclosure will become apparent with the detailed description of embodiments and the accompanied drawings as follows. However, it shall be noted that the accompanied drawings are for illustrative purposes only such that they shall not be used to restrict the scope of the present disclosure.

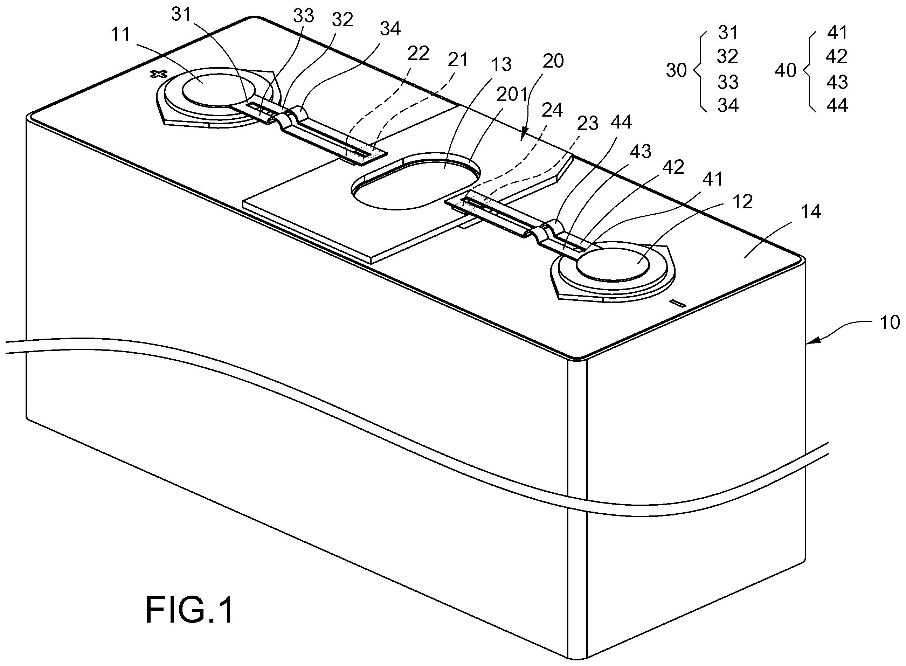

The present disclosure provides a battery cell monitoring module. Please refer to FIG. 1, which is the perspective appearance view of the first embodiment of the present disclosure, the battery cell monitoring module of the present disclosure mainly includes a battery cell 10, a circuit board 20, a positive conductor 30, and a negative conductor 40.

In the embodiment, the battery cell 10 is a rectangular body, but the present disclosure is not limited to this embodiment. The battery cell 10 has a positive electrode head 11, a negative electrode head 12, and an insulating cover 14. The insulating cover 14 in the embodiment is arranged on a top of the battery cell 10, and the positive electrode head 11 and the negative electrode head 12 are arranged on the insulating cover 14. In addition, the positive electrode head 11 and the negative electrode head 12 in the embodiment are both flat electrode head, but the positive electrode head 11 and the negative electrode head 12 may also be internal threaded electrode head, external threaded electrode head, or cylinder electrode head. A shell of the battery cell 10 is made of metal. A flat area is arranged on a top of the shell of the battery cell 10 and is coated with an insulating material to form the insulating cover 14.

The circuit board 20 is arranged and directly attached on the insulating cover 14, that is, there is no supporting member, insulating member, or other member between the insulating cover 14 and the circuit board 20. In detail, the circuit board 20 is arranged on the insulating cover 14 with the positive electrode head 11 and the negative electrode head 12, and the circuit board 20 in the embodiment is located between the positive electrode head 11 and the negative electrode head 12. The circuit board 20 mainly has a positive power pad 21, a positive voltage pad 22, a negative power pad 23, and a negative voltage pad 24. The positive power pad 21 and the positive voltage pad 22 are located on the same side of the circuit board 20 and adjacent to the positive electrode head 11. The negative power pad 23 and the negative voltage pad 24 are located on the same side of the circuit board 20 and adjacent to the negative electrode head 12. However, the positions of the positive power pad 21, the positive voltage pad 22, the negative power pad 23, and the negative voltage pad 24 are not limited to this embodiment.

In the embodiment, the positive conductor 30 is made of copper alloy. The positive conductor 30 is arranged on the insulating cover 14, and the positive conductor 30 is electrically connected to the positive electrode head 11 and the circuit board 20. In detail, the positive conductor 30 is configured to correspond to the positive electrode head 11 and the circuit board 20. The positive conductor 30 includes a positive connecting portion 31, a positive power pin 32, and a positive voltage pin 33. The positive connecting portion 31 is electrically connected to the positive electrode head 11. The positive power pin 32 is electrically connected to the positive connecting portion 31 and the positive power pad 21. The positive voltage pin 33 is electrically connected to the positive connecting portion 31 and the positive voltage pad 22. In other words, the positive electrode head 11 is respectively electrically connected to the positive power pin 32 and the positive voltage pin 33 through the positive connecting portion 31, and the positive power pin 32 and the positive voltage pin 33 are respectively electrically connected to the positive power pad 21 and the positive voltage pad 22 of the circuit board 20.

In the embodiment, the negative conductor 40 is made of copper alloy. Similar to the positive conductor 30, the negative conductor 40 is arranged on the insulating cover 14, and the negative conductor 40 is electrically connected to the negative electrode head 12 and the circuit board 20. In detail, the negative conductor 40 is configured to correspond to the negative electrode head 12 and the circuit board 20. The negative conductor 40 includes a negative connecting portion 41, a negative power pin 42, and a negative voltage pin 43. The negative connecting portion 41 is electrically connected to the negative electrode head 12. The negative power pin 42 is electrically connected to the negative connecting portion 41 and the negative power pad 23. The negative voltage pin 43 is electrically connected to the negative connecting portion 41 and the negative voltage pad 24. The negative electrode head 12 is respectively electrically connected to the negative power pin 42 and the negative voltage pin 43 through the negative connecting portion 41, and the negative power pin 42 and the negative voltage pin 43 are respectively electrically connected to the negative power pad 23 and the negative voltage pad 24 of the circuit board 20.

Therefore, the positive power pad 21 and the negative power pad 23 of the circuit board 20 are respectively electrically connected to the positive electrode head 11 and the negative electrode head 12 of the battery cell 10 through the positive power pin 32 of the positive conductor 30 and the negative power pin 42 of the negative conductor 40, so as to form an independent power circuit 25 to make the battery cell 10 to supply power to the circuit board 20. The positive voltage pad 22 and the negative voltage pad 24 of the circuit board 20 are respectively electrically connected to the positive electrode head 11 and the negative electrode head 12 of the battery cell 10 through the positive voltage pin 33 of the positive conductor 30 and the negative voltage pin 43 of the negative conductor 40 to form a voltage detection circuit 26. The power circuit 25 and the voltage detection circuit 26 are independent to each other, and the measurement of the voltage detection circuit 26 will not be disturbed or affected by the power circuit 25, so as to improve the stability and accuracy of voltage measurement.

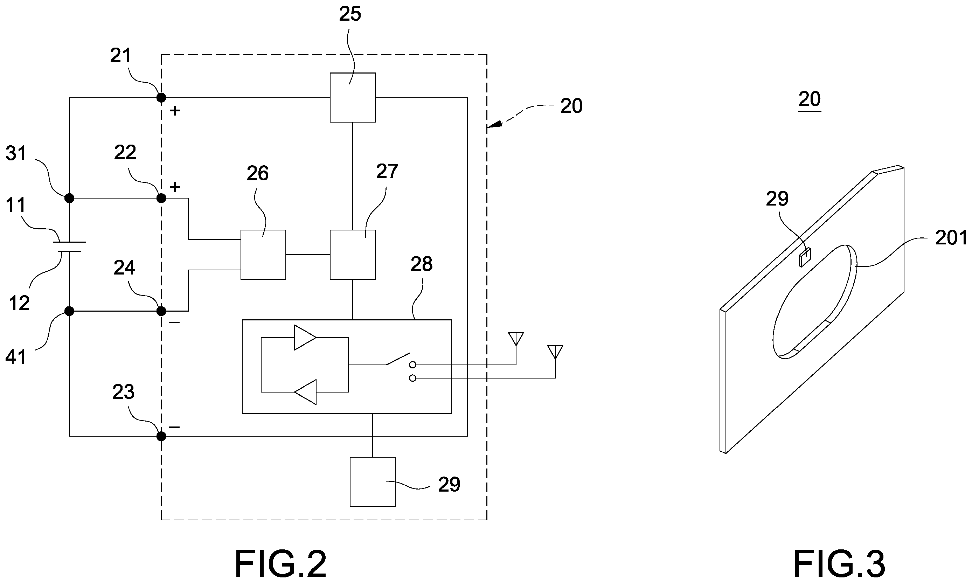

Details are provided as follows. Please refer to FIG. 2 and FIG, 3 with FIG. 1, FIG. 2 and FIG. 3 are respectively the circuit diagram of the battery cell 10, the positive conductor 30, the negative conductor 40, and the circuit board 20 of the present disclosure and the perspective appearance view of rear side of the circuit board 20 of the present disclosure. The circuit board 20 has the power circuit 25, the voltage detection circuit 26, a signal processor 27, a wireless signal transceiver 28, and a temperature sensor 29. Therefore, the circuit board 20 may measure current, voltage, temperature, and other parameters of the battery cell 10 and then transmit them to the outside for user monitoring. Details are provided as follows.

The power circuit 25 of the circuit board 20 forms a loop with the positive electrode head 11 and the negative electrode head 12 of the battery cell 10 through the positive power pin 32 and the negative power pin 42, such that the battery cell 10 may supply power to the voltage detection circuit 26, the signal processor 27, the wireless signal transceiver 28, and the temperature sensor 29 of the circuit board 20.

The voltage detection circuit 26 forms a loop with the positive electrode head 11 and the negative electrode head 12 of the battery cell 10 through the positive voltage pin 33 and the negative voltage pin 43. Since a resistance of the voltage detection circuit 26 is much greater than a resistance of the power circuit 25, a current value passing through the voltage detection circuit 26 is extremely small to ensure that the stability and accuracy of voltage measurement are not disturbed or affected by the current.

The signal processor 27 is used to convert a detected voltage signal into a numerical value and transmit it to the wireless signal transceiver 28, and then the converted voltage value is wirelessly transmitted to an external battery management system (BMS) through the wireless signal transceiver 28 for user monitoring. In the embodiment, the wireless signal transceiver 28 may be Bluetooth transceiver or WIFI transceiver, but the present disclosure is not limited to this embodiment.

The temperature sensor 29 is used to measure a temperature of the battery cell 10, so as to determine whether the current temperature of the battery cell 10 is within a normal operating temperature range. In detail the temperature sensor 29 is arranged on the circuit board 20, and at least part of a measurement pad of the temperature sensor 29 is located on a bottom surface of the circuit board 20 (that is a side of the circuit board 20 away from the positive power pad 21, the positive voltage pad 22, the negative power pad 23, and the negative voltage pad 24). Therefore, since the circuit board 20 is directly attached and arranged on the insulating cover 14 of the battery cell 10, the measurement pad of the temperature sensor 29 located on the bottom surface of the circuit board 20 may be directly attached on the insulating cover 14 to measure the temperature of the battery cell 10, and then the wireless signal transceiver 28 transmits it to external BMS for user monitoring. It is worth noting that the measurement pad may be protruding out of or flush with the bottom surface of the circuit board 20, the present disclosure does not limit this. In addition, the insulating cover 14 in the embodiment is formed by a copper plate coated with an insulating layer such that the measurement pad of the temperature sensor 29 may be directly attached to the insulating cover 14 of the battery cell 10. Therefore, the temperature sensor 29 may directly and quickly measure the current temperature of the battery cell 10 without too much error.

In addition, the circuit board 20 of the present disclosure may further have an electrochemical impedance spectroscopy (EIS) circuit. The EIS circuit may detect a change of the impedance of the battery cell 10 through a voltage signal measured by the positive voltage pin 33 and the negative voltage pin 43 with the voltage detection circuit 26, so as to monitor health of the battery cell 10 through changes in the impedance and transmit it by the wireless signal transceiver 28 to external BMS for user monitoring.

Please refer to FIG. 1 again, details of the detail structure of the battery cell monitoring module of the present disclosure are provided as follows. The positive conductor 30 in the embodiment has a positive buffer portion 34. The positive buffer portion 34 is arranged on at least one of the positive power pin 32 and the positive voltage pin 33, and the positive buffer portion 34 is arc-shaped, V-shaped, U-shaped, or other shapes having a collapse space. In the embodiment, the positive buffer portion 34 is arranged on both the positive power pin 32 and the positive voltage pin 33 and is an arc structure convex upward, so as to absorb a dimensional tolerance between the positive electrode head 11 and the circuit board 20 through the elastic deformation of the positive buffer portion 34, but the present disclosure is not limited to this embodiment. For example, the positive buffer portion 34 may also be concave downward instead of being convex. The negative conductor 40 in the embodiment has a negative buffer portion 44. The negative buffer portion 44 is arranged on at least one of the negative power pin 42 and the negative voltage pin 43, and the negative buffer portion 44 is arc-shaped, V-shaped, U-shaped, or other shapes having a collapse space. In the embodiment, the negative buffer portion 44 is arranged on both the negative power pin 42 and the negative voltage pin 43 and is an arc structure convex upward, so as to absorb (allow) a dimensional tolerance between the negative electrode head 12 and the circuit board 20 through the elastic deformation of the negative buffer portion 44, but the present disclosure is not limited to this embodiment. For example, the negative buffer portion 44 may also be concave downward instead of being convex upward.

Details are provided as follows. The positive connecting portion 31 and the negative connecting portion 41 are both two-point type, strip-shaped, rectangle, arc, semicircle, or ring-shaped. In the embodiment, the positive connecting portion 31 and the negative connecting portion 41 are both strip-shaped and substantially perpendicular to the positive power pin 32, the positive voltage pin 33, the negative power pin 42, and the negative voltage pin 43. In addition, the positive power pin 32, the positive voltage pin 33, the negative power pin 42, and the negative voltage pin 43 are all strip-shaped, plate-shaped, or line-shaped. In the embodiment, the positive power pin 32, the positive voltage pin 33, the negative power pin 42, and the negative voltage pin 43 are all strip-shaped and substantially parallel to each other. However, the positive power pin 32 and the positive voltage pin 33 may also be configured to be inverted V-shaped, or the positive power pin 32 may also be parallel to the positive voltage pin 33 without being parallel to the negative power pin 42 and the negative voltage pin 43. The arrangement of the positive power pin 32 and the positive voltage pin 33 may be adjusted according different needs.

In addition, the battery cell 10 of the present disclosure further has an exhaust valve 13. The exhaust valve 13 is arranged on the insulating cover 14. A thickness of the insulating cover 14 changes correspondingly a position of to the exhaust valve 13 such that the exhaust valve 13 may reduce a pressure when an internal pressure of the battery cell 10 is increasing. In the embodiment, the circuit board 20 has a through slot 201. A position of the through slot 201 is corresponding to a position of the exhaust valve 13 to prevent the circuit board 20 from covering the through slot 201. However, the circuit board 20 may also be arranged on a side of the exhaust valve 13 and the through slot 201 may be dispensed with, that is, the exhaust valve 13 may be arranged between the circuit board 20 and the positive conductor 30 or between the circuit board 20 and the negative conductor 40.

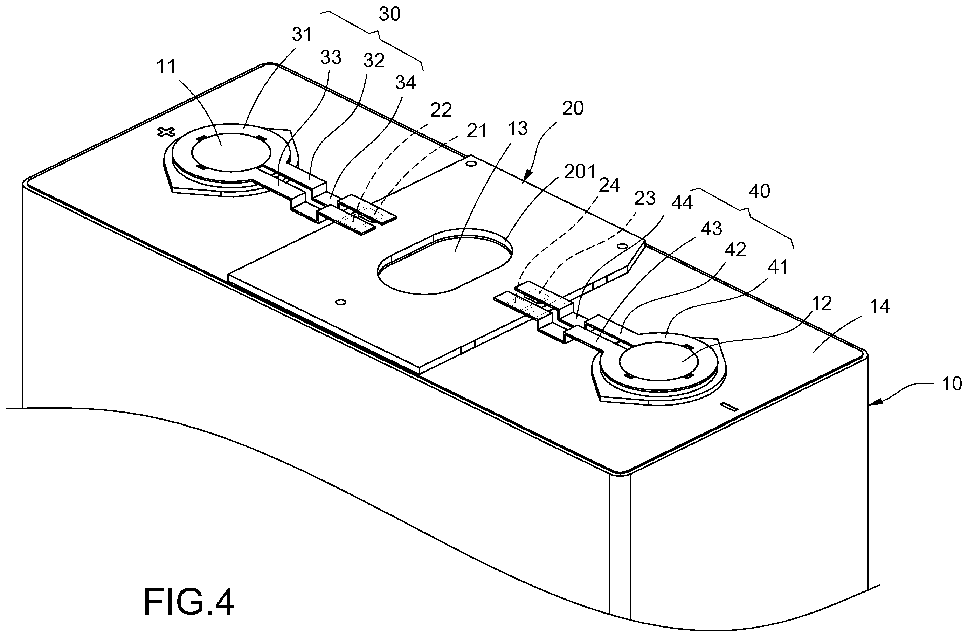

Please refer to FIG. 4, which is the partial perspective appearance view of the second embodiment of the present disclosure. The difference between the first embodiment and the second embodiment is the form of the positive connecting portion 31, the negative connecting portion 41, the positive buffer portion 34, and the negative buffer portion 44. Details are provided as follows. In the embodiment, the positive connecting portion 31 and the negative connecting portion 41 are both ring-shaped to be positioning and adapted to sheathe the corresponding positive electrode head 11 and the corresponding negative electrode head 12, so as to facilitate welding and fixing of the positive conductor 30 and the negative conductor 40. In addition, the positive connecting portion 31 and the negative connecting portion 41 in the embodiment respectively have a plurality of notches (not labeled in figures) defined on an inner edge such that the positive connecting portion 31 and the negative connecting portion 41 may not crack or damage when they are adapted to sheathe the positive electrode head 11 and the negative electrode head 12, but the present disclosure is not limited to this embodiment. In addition, the positive buffer portion 34 and the negative buffer portion 44 in the embodiment are both U-shaped structure concave downward, so as to prevent them from deforming by collision or impact because of being too protruding.

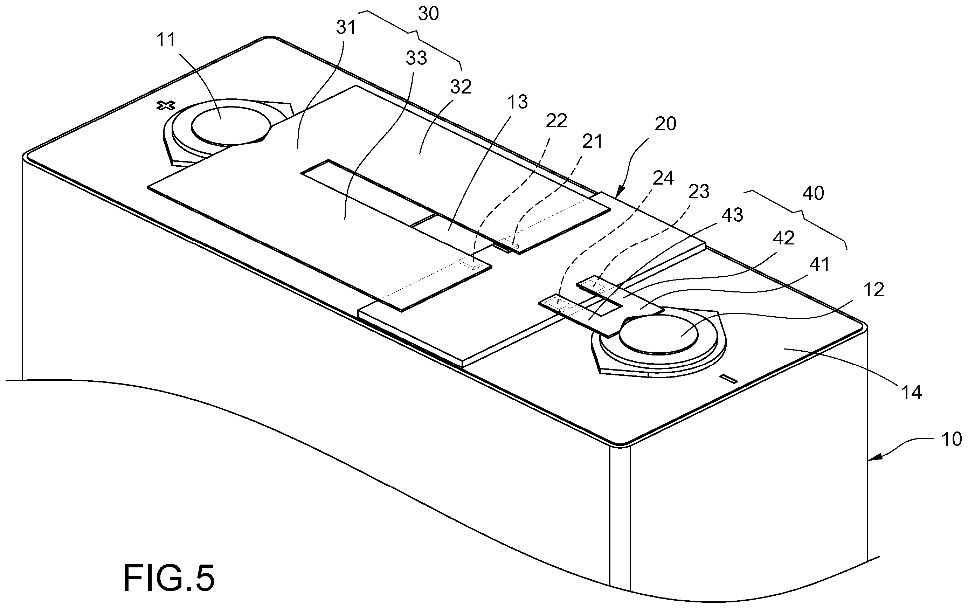

Please refer to FIG. 5, which is the partial perspective appearance view of the third embodiment of the present disclosure. The differences between the first embodiment and the third embodiment are the form of the positive conductor 30 and the negative conductor 40 and the arrangement position of the circuit board 20, and the third embodiment does not have the positive buffer portion 34 and the negative buffer portion 44 in the first embodiment. Details are provided as follows. In the embodiment, the positive connecting portion 31 and the negative connecting portion 41 are both rectangular, and the positive power pin 32, the positive voltage pin 33, negative power pin 42, and the negative voltage pin 43 are all plate-shaped. Therefore, the positive conductor 30 and the negative conductor 40 may increase its volume and surface area while maintaining the same thickness, so as to improve the heat dissipation efficiency of the positive conductor 30 and the negative conductor 40 to cope with the high temperature generated during operation of the battery cell 10. In addition, since neither the positive conductor 30 nor the negative conductor 40 in the embodiment has the positive buffer portion 34 and the negative buffer portion 44, the lengths of the positive power pin 32, the positive voltage pin 33, the negative power pin 42, and the negative voltage pin 43 are longer than the lengths in the first embodiment. Therefore, the positive conductor 30 and the negative conductor 40 not only may further improve its heat dissipation efficiency, but also absorb the dimensional tolerance between the positive electrode head 11 and the circuit board 20 and the dimensional tolerance between the negative electrode head 12 and the circuit board 20. Furthermore, the circuit board 20 in the embodiment is arranged on a side of the exhaust valve 13 of the battery cell 10. Therefore, the circuit board 20 may not affect the air pressure balance inside the battery cell 10 and the through groove 201 may be omitted, such that circuit board 20 may have a larger area to arrange electronic components.

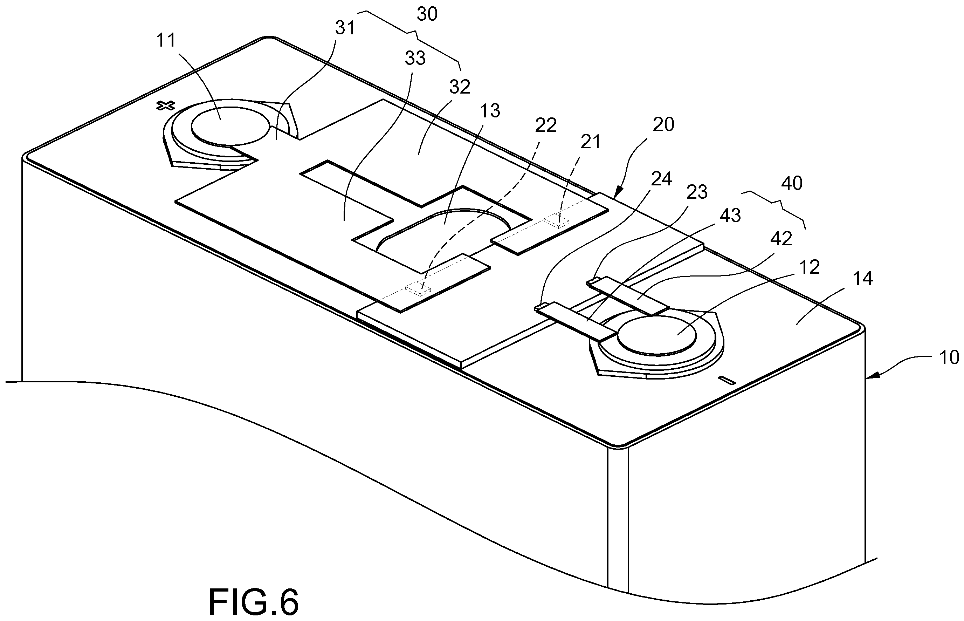

Please refer to FIG. 6, which is the partial perspective appearance view of the fourth embodiment of the present disclosure. The difference between the fourth embodiment and the third embodiment is the form of the positive power pin 32, the positive voltage pin 33, and the negative connecting portion 41. Details are provided as follows. In the embodiment, the positive power pin 32 and the positive voltage pin 33 respectively have a plurality of notches (not labeled in figures) that its positions are corresponding to a location of the exhaust valve 13, so as to prevent the positive power pin 32 and the positive voltage pin 33 from covering the exhaust valve 13 to affect the air pressure balance inside the battery cell 10. In addition, the negative connecting portion 41 (not labeled in FIG. 6) in the embodiment is two-point type, that is, the negative power pin 42 and the negative voltage pin 43 are directly welded to the negative electrode head 12 through two points to effectively reduce production costs.

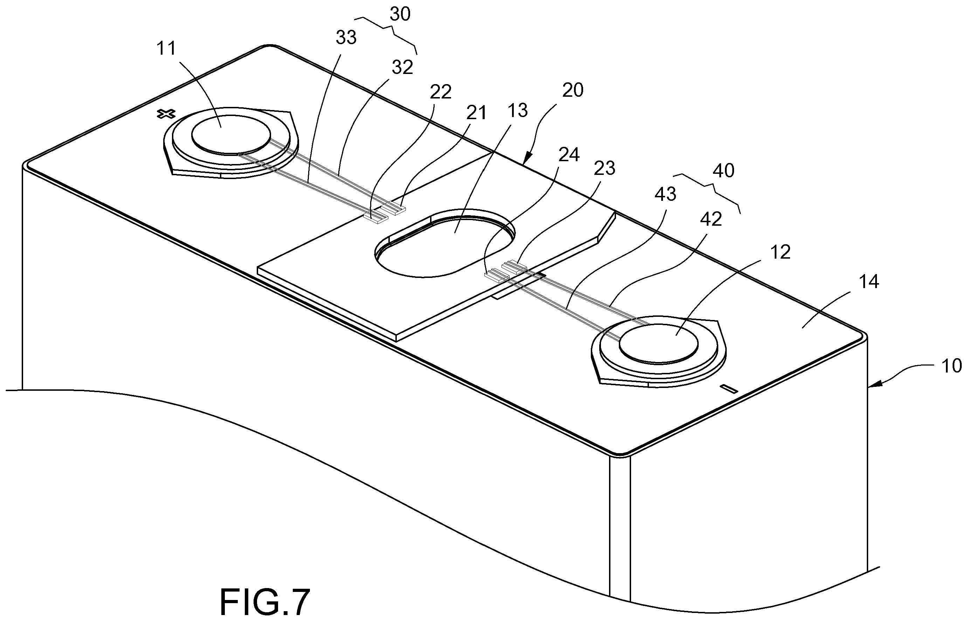

Please refer to FIG. 7, which is the partial perspective appearance view of the fifth embodiment of the present disclosure. The difference between the fifth embodiment and the first embodiment is the form of the positive power pin 32, the positive voltage pin 33, the negative power pin 42, and the negative voltage pin 43. Details are provided as follows. In the embodiment, the positive power pin 32, the positive voltage pin 33, the negative power pin 42, and the negative voltage pin 43 are all line-shaped. In detail, the positive power pin 32, the positive voltage pin 33, the negative power pin 42, and the negative voltage pin 43 in the embodiment are arranged by wire bonding, so as to effectively reduce production costs and reduce the volume of the positive power pin 32, the positive voltage pin 33, the negative power pin 42, and the negative voltage pin 43 to reduce the chance of damage from collision or impact.

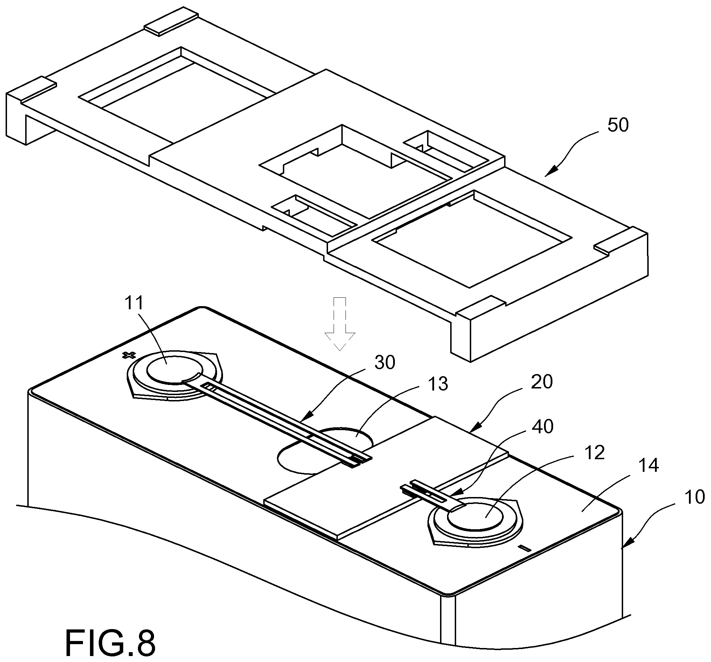

Please refer to FIG. 8 and FIG .9, which are respectively the partial exploded view of the sixth embodiment of the present disclosure and the partial perspective appearance view of the sixth embodiment of the present disclosure. The difference between the sixth embodiment and the first embodiment is that the sixth embodiment further includes an outer cover 50. In the embodiment, the outer cover 50 is in one-piece form by plastic injection molding, but the present disclosure is not limited to this embodiment, as long as the outer cover 50 is made of insulating material. The outer cover 50 is arranged on the insulating cover 14 of the battery cell 10, and the outer cover 50 covers at least part of the circuit board 20, at least part of the positive conductor 30, and at least part of the negative conductor 40 to protect the circuit board 20, the positive conductor 30, and the negative conductor 40. Therefore, the battery cell monitoring module of the present disclosure may prevented the circuit board 20, the positive conductor 30, and the negative conductor 40 from deforming or damaging because of collision or impact.

It is worth noting that the above description of the embodiments and the content of figures of the present disclosure are only intended to enable those with ordinary skills in the art of the technical field of the present disclosure to understand and implement instead of limiting the battery cell monitoring module of the present disclosure to only be implemented in these six embodiments. In other words, a person with ordinary skills in the art of the technical field of the present disclosure may make various changes and modifications corresponding to the present disclosure without deviating the principle and substance of the present disclosure. However, such corresponding changes and modification shall be considered to be within the claimed scope of the present disclosure.

In the battery cell monitoring module of the present disclosure, the positive conductor 30 has the positive power pin 32 and the positive voltage pin 33 that are respectively electrically connected to the positive power pad 21 and the positive voltage pad 22 of the circuit board 20, and the negative conductor 40 has the negative power pin 42 and the negative voltage pin 43 that are respectively electrically connected to the negative power pad 23 and the negative voltage pad 24 of the circuit board 20. Therefore, the battery cell 10 may form an independent circuit with the circuit board 20 through the positive power pin 32 and the negative power pin 42 to supply power, and the circuit board 20 may measure the voltage of the battery cell 10 through the positive voltage pin 33 and the negative voltage pin 43 to reduce interference or influence from other circuits such as power, so as to improve the stability and accuracy of voltage measurement.

As will become apparent to the skilled person when studying the above disclosure, the subject-matter of the appended claims can also be combined in a different manner as specifically claimed. In particular the term "according to claim 1" and similar shall be deemed to encompass also the meaning "according to any of the preceding (antecedent) claims".

## Claims

1. A battery cell monitoring module, comprising:
a battery cell (10), comprising a positive electrode head (11), a negative electrode head (12), and an insulating cover (14), the positive electrode head (11) and the negative electrode head (12) arranged on the insulating cover (14);
a circuit board (20), arranged on the insulating cover (14) and comprising a positive power pad (21), a positive voltage pad (22), a negative power pad (23), and a negative voltage pad (24);
a positive conductor (30), arranged on the battery cell (10) and comprising a positive connecting portion (31), a positive power pin (32), and a positive voltage pin (33), the positive connecting portion (31) electrically connected to the positive electrode head (11), the positive power pin (32) electrically connected to the positive connecting portion (31) and the positive power pad (21), the positive voltage pin (33) electrically connected to the positive connecting portion (31) and the positive voltage pad (22);
a negative conductor (40), arranged on the battery cell (10) and comprising a negative connecting portion (41), a negative power pin (42), and a negative voltage pin (43), the negative connecting portion (41) electrically connected to the negative electrode head (12), the negative power pin (42) electrically connected to the negative connecting portion (41) and the negative power pad (23), the negative voltage pin (43) electrically connected to the negative connecting portion (41) and the negative voltage pad (24).

2. The battery cell monitoring module according to claim 1, wherein the positive conductor (30) comprises a positive buffer portion (34), the positive buffer portion (34) is arranged on at least one of the positive power pin (32) and the positive voltage pin (33).

3. The battery cell monitoring module according to claim 2, wherein the positive buffer portion (34) is arc-shaped, V-shaped, or U-shaped.

4. The battery cell monitoring module according to claim 1, wherein the negative conductor (40) comprises a negative buffer portion (44), the negative buffer portion (44) is arranged on at least one of the negative power pin (42) and the negative voltage pin (43).

5. The battery cell monitoring module according to claim 4, wherein the negative buffer portion (44) is arc-shaped, V-shaped, or U-shaped.

6. The battery cell monitoring module according to claim 1, wherein the positive connecting portion (31) and the negative connecting portion (41) are both strip-shaped, rectangle, arc, semicircle, or ring-shaped.

7. The battery cell monitoring module according to claim 1, wherein the positive power pin (32), the positive voltage pin (33), the negative power pin (42), and the negative voltage pin (43) are all strip-shaped, plate-shaped, or line-shaped.

8. The battery cell monitoring module according to claim 1, further comprising an outer cover (50), wherein the outer cover (50) is arranged on the insulating cover (14) and covers at least part of the circuit board (20), at least part of the positive conductor (30), and at least part of the negative conductor (40).

9. The battery cell monitoring module according to claim 1, wherein the battery cell (10) comprises an exhaust valve (13), the circuit board (20) comprises a through slot (201), a position of the through slot (201) is corresponding to a position of the exhaust valve (13).

10. The battery cell monitoring module according to claim 1, wherein the battery cell (10) comprises an exhaust valve (13), the exhaust valve (13) is arranged between the circuit board (20) and the positive conductor (30) or between the circuit board (20) and the negative conductor (40).
